# EUROPEAN PATENT APPLICATION

(11) **EP 2 860 754 A1**
(43) Date of publication of application: **15.04.2015**
(21) Application number: 14162499.9
(22) Date of filing: 28.03.2014
(51) Int. Cl.: H01L 21/67

(54) **Apparatus and method for removing static electricity from substrate**

(30) Priority: 10.10.2013 KR 20130120653
(71) Applicant: Samsung Display Co., Ltd., Gyeonggi-Do (KR)
(72) Inventor: Lee, Dong Hoon, Chungcheongnam-do (KR)
(74) Representative: Taor, Simon Edward William

(57) **Abstract**

Provided are an apparatus and method for removing static electricity from a substrate. The apparatus includes: a vacuum chamber; a substrate stage which is installed inside the vacuum chamber; and a first electrode and a second electrode which are installed inside the vacuum chamber and physically separated from the substrate stage, wherein an electric field is formed between the first electrode and the second electrode by different voltages applied to the first electrode and the second electrode, and at least part of the substrate stage is placed within the electric field.

## Description

The present invention relates to an apparatus and method for removing static electricity from a substrate.

Substrates for displays (such as organic light-emitting displays, liquid crystal displays and plasma displays) go through a number of manufacturing processes before becoming finished products. For example, substrates for displays go through a process chamber in an atmospheric state, a process chamber in a vacuum state, and a load lock chamber in a vacuum state. A large number of gas molecules exist within the process chamber in the atmospheric state, and these gas molecules are made to flow by an external force. On the other hand, few gas molecules exist within the process chamber in the vacuum state and the load lock chamber in the vacuum state. Since a very small amount, if any, of gas molecules exist in these chambers, there is virtually no flow of gas molecules.

While going through the process chamber in the atmospheric state, the process chamber in the vacuum, and the load lock chamber in the vacuum, the substrates for displays may be affected by static electricity generated by surrounding elements used in processes.

Since gas molecules do flow within the process chamber in the atmospheric state, static electricity can be removed from a substrate fed into the process chamber in the atmospheric state by supplying ions to the flowing gas molecules using an ionizer. That is, ions supplied by the ionizer may ionize the flowing gas molecules, and the ionized gas molecules may neutralize a portion of the substrate, which is charged with static electricity, as they reach the portion of the substrate.

However, the ionizer used to remove static electricity from a substrate fed into the process chamber in the atmospheric state can remove the static electricity of the substrate only when there is a flow of gas molecules. Therefore, it is difficult to use the ionizer to remove static electricity from a substrate in the process chamber in the vacuum and the load lock chamber in the vacuum state where there is no flow of gas molecules. Unless the static electricity is effectively removed, the quality of the substrate can be degraded by the static electricity.

Aspects of the present invention provide an apparatus for removing static electricity from a substrate, the apparatus capable of preventing a substrate in a vacuum chamber from being damaged by static electricity by neutralizing and thus removing the static electricity of the substrate.

Aspects of the present invention also provide a method of removing static electricity from a substrate, the method capable of preventing a substrate in a vacuum chamber from being damaged by static electricity by neutralizing and thus removing the static electricity of the substrate.

However, aspects of the present invention are not restricted to the one set forth herein. The above and other aspects of the present invention will become more apparent to one of ordinary skill in the art to which the present invention pertains by referencing the detailed description of the present invention given below.

According to an aspect of the present invention, there is provided an apparatus for removing static electricity from a substrate. The apparatus includes: a vacuum chamber; a substrate stage which is installed inside the vacuum chamber; and a first electrode and a second electrode which are installed inside the vacuum chamber and physically separated from the substrate stage, wherein an electric field is formed between the first electrode and the second electrode by different voltages applied to the first electrode and the second electrode, and at least part of the substrate stage is placed within the electric field.

A positive voltage may be applied to the first electrode, and a negative voltage may be applied to the second electrode, wherein an absolute value of the positive voltage may be equal to an absolute value of the negative voltage.

The first electrode and the second electrode may be alternately arranged along a first direction of the substrate stage to form one column consisting of two or more electrodes.

The substrate stage may be configured to be moved along a second direction perpendicular to the first direction.

In the first direction, a distance between an outermost first electrode and an outermost second electrode may be smaller or greater than a width of a substrate placed on the substrate stage.

In the second direction perpendicular to the first direction, a width of each of the first electrode and the second electrode may be smaller than half a width of the substrate placed on the substrate stage.

The apparatus may further include: a bar-shaped fixing unit which is installed inside the vacuum chamber and to which the one column is fixed; couplers which are installed inside the vacuum chamber, coupled respectively to the first electrode and the second electrode, and coupled to the fixing unit by bolts such that the couplers can move along the fixing unit; a power supply unit which is installed outside the vacuum chamber and electrically connected to each of the first electrode and the second electrode so as to apply the different voltages to the first electrode and the second electrode; and a control unit which controls the voltage application of the power supply unit.

The one column may be repeated along the second direction perpendicular to the first direction to form a plurality of columns.

In the second direction, a distance between an outermost first electrode and an outermost second electrode may be equal to or greater than the width of the substrate placed on the substrate stage.

The first electrode and the second electrode may be alternately arranged along the first direction of the substrate stage to form one column consisting of two or more electrodes and extend along the second direction perpendicular to the first direction.

In the second direction, a length of each of the first electrode and the second electrode may be equal to or greater than the width of the substrate placed on the substrate stage.

The apparatus may further include: a plate-shaped fixing unit which is installed inside the vacuum chamber and to which the first electrode and the second electrode are fixed; a power supply unit which is installed outside the vacuum chamber and electrically connected to each of the first electrode and the second electrode so as to apply the different voltages to the first electrode and the second electrode; and a control unit which controls the voltage application of the power supply unit.

The vacuum chamber may be a process chamber in which a process of manufacturing the substrate placed on the substrate stage is performed, wherein the substrate stage may be an electrostatic chuck.

The vacuum chamber may be a load lock chamber which provides a space where the substrate is standing by before or after the process of manufacturing the substrate placed on the substrate stage is performed, wherein the substrate stage may be a roller.

According to another aspect of the present invention, there is provided a method of removing static electricity from a substrate. The method includes: placing at least part of a substrate mounted on a substrate stage, which is installed inside a vacuum chamber, under a first electrode and a second electrode which are installed inside the vacuum chamber and physically separated from the substrate stage; and forming an electric field between the first electrode and the second electrode by applying different voltages to the first electrode and the second electrode.

The forming of the electric field may include horizontally moving the substrate by horizontally moving the substrate stage along a second direction perpendicular to a first direction in which the first electrode and the second electrode are arranged.

The forming of the electric field may be performed before the substrate exits the vacuum chamber.

Before the substrate exits the vacuum chamber may be immediately before the substrate is separated from the substrate stage.

According to an aspect of the present invention, there is provided an apparatus for removing static electricity from a substrate as set out in claim 1. Preferred features of this aspect are set out in claims 2 to 11.

According to an aspect of the present invention, there is provided a method for removing static electricity from a substrate as set out in claim 12. Preferred features of this aspect are set out in claims 13 to 15.

The above and other aspects and features of the present invention will become more apparent by describing in detail exemplary embodiments thereof with reference to the attached drawings, in which:
FIG. 1 is a cross-sectional view of an apparatus for removing static electricity from a substrate according to an embodiment of the present invention;
FIG. 2 is a cross-sectional view illustrating some elements to explain the principle of removing static electricity from a substrate using an electric field between a first electrode and a second electrode shown in FIG. 1;
FIG. 3 is a perspective view of the first electrode, the second electrode, and a substrate of FIG. 1;
FIG. 4 is a bottom view of the first electrode, the second electrode, and a fixing unit of FIG. 3;
FIG. 5 is a cross-sectional view illustrating the positional relationship among the first electrode, the second electrode, and the substrate;
FIG. 6 is a cross-sectional view illustrating another positional relationship among the first electrode, the second electrode, and the substrate of FIG. 3;
FIG. 7 is a bottom view illustrating another arrangement of the first electrode and the second electrode which is different from the arrangement of FIG. 4;
FIG. 8 is a perspective view of another example of the first electrode, the second electrode, and the substrate of FIG. 3;
FIG. 9 is a bottom view of first electrodes, second electrodes, and fixing units of FIG. 8;
FIG. 10 is a perspective view of another example of the first electrode, the second electrode, and the substrate of FIG. 3;
FIG. 11 is a bottom view of a first electrode, a second electrode, and a fixing unit of FIG. 10; and
FIG. 12 is a cross-sectional view of an apparatus for removing static electricity from a substrate according to another embodiment of the present invention.

Advantages and features of the present invention and methods of accomplishing the same may be understood more readily by reference to the following detailed description of exemplary embodiments and the accompanying drawings. The present invention may, however, be embodied in many different forms and should not be construed as being limited to the embodiments set forth herein. Rather, these embodiments are provided so that this disclosure will be thorough and complete and will fully convey the concept of the invention to those skilled in the art, and the present invention will only be defined by the appended claims.

It will be understood that when an element or layer is referred to as being "on" another element or layer, the element or layer can be directly on another element or layer or intervening elements or layers. Like numbers refer to like elements throughout.

It will be understood that, although the terms first, second, third, etc., may be used herein to describe various elements, these elements should not be limited by these terms. These terms are only used to distinguish one element from another element. Thus, a first element discussed below could be termed a second element without departing from the teachings of the present invention.

Hereinafter, embodiments of the present invention will be described with reference to the attached drawings.

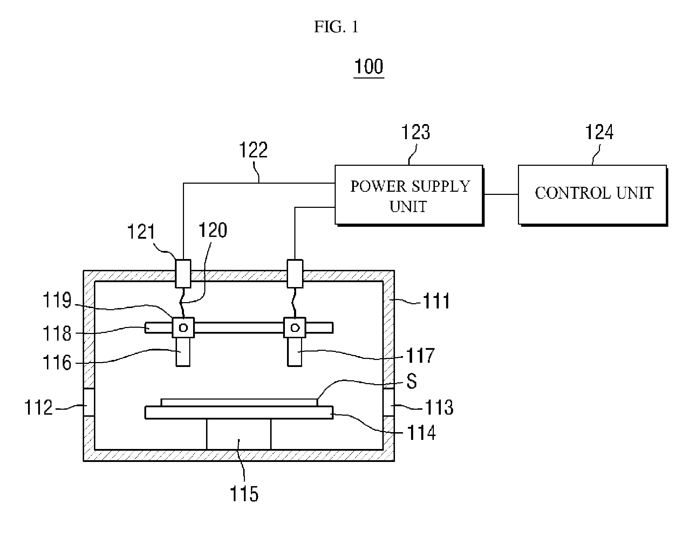

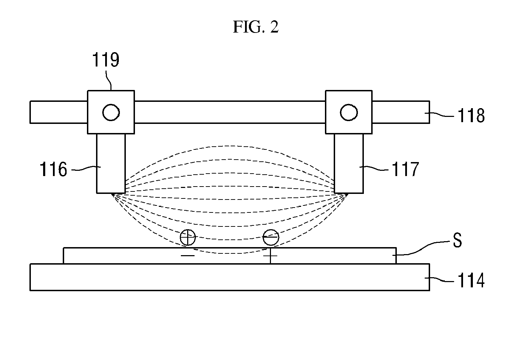

FIG. 1 is a cross-sectional view of an apparatus 100 for removing static electricity from a substrate according to an embodiment of the present invention. FIG. 2 is a cross-sectional view illustrating some elements to explain the principle of removing static electricity from a substrate S using an electric field between a first electrode 116 and a second electrode 117 shown in FIG. 1.

Referring to FIG. 1, the static electricity removing apparatus 100 according to the current embodiment includes a vacuum chamber 111, a substrate stage 114, the first electrode 116, the second electrode 117, a fixing unit 118, couplers 119, a power supply unit 123, and a control unit 124.

The vacuum chamber 111 forms an internal space in which a constant vacuum can be created. The vacuum chamber 111 may be a process chamber that provides a space in which a specific process is performed to manufacture a display device. The vacuum chamber 111 maintains a vacuum state, depending on a process performed therein. When the vacuum chamber 111 is in the vacuum state, only a very small amount of gas molecules exist within the vacuum chamber 111. Therefore, there is virtually no flow of gas molecules.

The vacuum chamber 111 includes an inlet 112 and an outlet 113. The substrate S required for performing a process is fed into the vacuum chamber 111 through the inlet 112 and is discharged from the vacuum chamber 111 through the outlet 113. The feeding and discharging of the substrate S may be performed by a transfer device such as a robot (not shown). Although not shown in the drawing, a gas supply pipe may be installed at a side of the vacuum chamber 111, and a gas discharge pipe may be installed at the other side of the vacuum chamber 111. An inert gas, for example, an argon gas may be supplied into the vacuum chamber 111 through the gas supply pipe, and a process gas remaining within the vacuum chamber 111 after a process may be discharged through the gas discharge pipe.

The substrate stage 114 is installed inside the vacuum chamber 111 and provides a space on which the substrate S fed into the vacuum chamber 111 is placed. The substrate stage 114 not only provides a space on which the substrate S is placed but also carries out functions necessary for performing a process. For example, the substrate stage 114 may function as an electrostatic chuck that attaches the substrate S thereto by vacuum suction and may be horizontally moved by a driving device thereby to horizontally move the substrate S. A support 115 may further be formed under the substrate stage 114 to support the substrate stage 114. Although not shown in the drawing, a lift pin may be installed in the support 115. The lift pin may vertically move the substrate S placed on the substrate stage 114.

The first electrode 116 and the second electrode 117 are installed inside the vacuum chamber 111 and are physically separated from the substrate stage 114. Different voltages are applied to the first electrode 116 and the second electrode 117 to form an electric field between them, as shown in FIG. 2.

The electric field may charge a very small amount of gas molecules existing within the vacuum chamber 111 or may move the charged gas molecules in the direction of the electric field. For example, a positive voltage may be applied to the first electrode 116, and a negative voltage may be applied to the second electrode 117. In this case, a portion of the gas molecules may be charged to a plus (positive) polarity by the first electrode 116, and the other portion of the gas molecules may be charged to a minus (negative) polarity by the second electrode 117. Here, an absolute value of the positive voltage applied to the first electrode 116 may be equal to an absolute value of the negative voltage applied to the second electrode 117. If voltages of an equal size are applied to the first electrode 116 and the second electrode 117, it may be easy to strike a voltage balance between the first electrode 116 and the second electrode 117.

Gas molecules having the plus polarity may flow toward the second electrode 117 due to the electric field. If the substrate S is placed in the path of the gas molecules having the plus polarity and if static electricity having the minus polarity is present in the substrate S, the flowing gas molecules having the plus polarity may neutralize the static electricity having the minus polarity in the substrate S as they combine with the minus polarity of the substrate S. Similarly, gas molecules having the minus polarity may flow toward the first electrode 116 due to the electric field. As they flow, the gas molecules having the minus polarity may neutralize static electricity having the plus polarity in the substrate S which is placed in the path of the gas molecules having the minus polarity.

The static electricity of the substrate S may be generated in the process of manufacturing a display device. For example, if the substrate stage 114 functions as an electrostatic chuck, more static electricity may be generated. Therefore, part of the substrate stage 114 is placed within the electric field in order to remove the static electricity of the substrate S by using the electric field.

The fixing unit 118 is installed inside the vacuum chamber 111 and fixes the first electrode 116 and the second electrode 117 thereto. The fixing unit 118 may be bar-shaped.

The couplers 119 are installed inside the vacuum chamber 111 and connected to the first electrode 116 and the second electrode 117, respectively. In this embodiment, the couplers 119 are coupled to the fixing unit 118 by bolts and are capable of moving along the fixing unit 118. Other embodiments may use other fixing means.

Accordingly, a distance between the first electrode 116 and the second electrode 117 can be adjusted by the movement of the couplers 119. The distance between the first electrode 116 and the second electrode 117 can be adjusted according to the size of the substrate S and the manufacturing process conditions. Cables 120 may be connected to the couplers 119 and electrically connected to the first electrode 116 and the second electrode 117, respectively. Feedthroughs 121 installed on a wall of the vacuum chamber 111 may be electrically connected to the cables 120, respectively. Wirings 122 are electrically connected to the feedthroughs 122, respectively. Thus, voltages can be received from the power supply unit 123 via the wirings 122.

The power supply unit 123 applies different voltages to the first electrode 116 and the second electrode 117 through the wirings 122. The different voltages are applied to form an electric field between the first electrode 116 and the second electrode 117. The different voltages may be high voltages of, e.g., +9 kV and -9 kV.

The control unit 124 controls the voltage application of the power supply unit 123. For example, the control unit 124 controls different voltages to be applied to the first electrode 116 and the second electrode 117 before the substrate S exits the vacuum chamber 111. In an exemplary embodiment, different voltages may be applied to the first electrode 116 and the second electrode 117 immediately before the substrate S is separated from the substrate stage 114. The damage to the substrate S due to static electricity occurs greatly when the substrate S is separated from the substrate stage 114. However, if an electric field is generated before (e.g. immediately before) the separation of the substrate S from the substrate stage 114, the static electricity is neutralized quickly, thus preventing the damage to devices. In addition, the control unit 124 controls appropriate voltages to be applied to the first electrode 116 and the second electrode 117, such that an electric field of an appropriate intensity can be formed between the first electrode 116 and the second electrode 117 according to the distance between the first electrode 116 and the second electrode 117.

Various arrangements of the first electrode 116 and the second electrode 117 which are applied to the above-described static electricity removing apparatus 100 will hereinafter be described in greater detail.

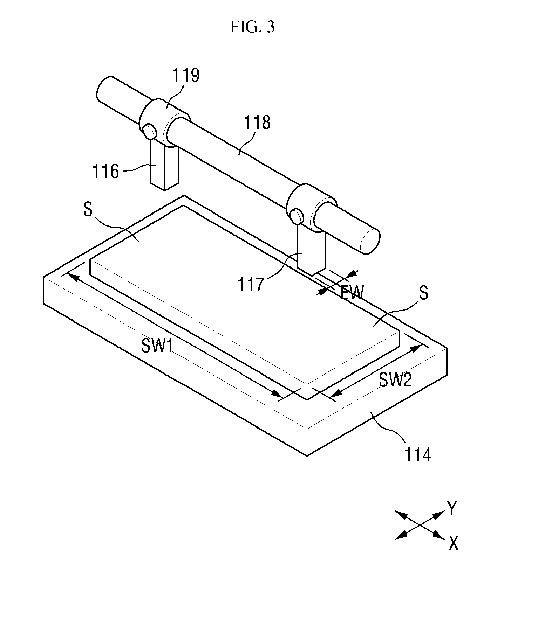

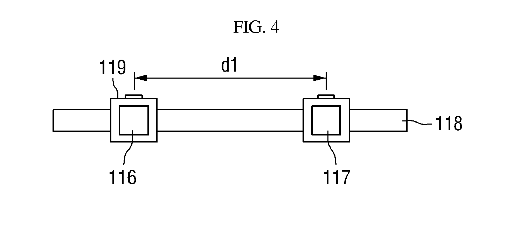

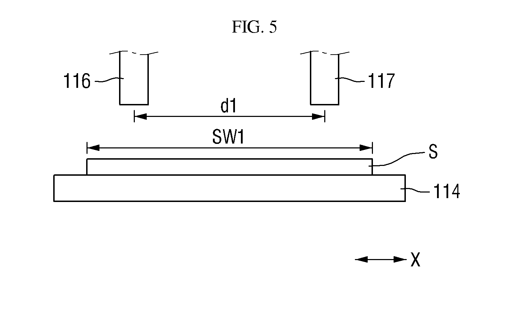

FIG. 3 is a perspective view of the first electrode 116, the second electrode 117, and the substrate S of FIG. 1. FIG. 4 is a bottom view of the first electrode 116, the second electrode 117, and the fixing unit 118 of FIG. 3. FIG. 5 is a cross-sectional view illustrating the positional relationship among the first electrode 116, the second electrode 117, and the substrate S.

In FIGS. 3 through 5, the first electrode 116 and the second electrode 117 are alternately arranged along a first direction X of the substrate stage 114 to form a column arrangement comprising two or more electrodes, for example, two electrodes.

If the first electrode 116 and the second electrode 117 form one column, the substrate stage 114 may be moved in a second direction Y perpendicular to the first direction X. Accordingly, if a width EW of each of the first electrode 116 and the second electrode 117 in the second direction Y is smaller than approximately half a width SW2 (in the second direction Y) of the substrate S placed on the substrate stage 114, the substrate S may be moved in the second direction Y such that the entire area of the substrate S can be easily exposed to an electric field between the first electrode 116 and the second electrode 117. As a result, this can increase the effect of neutralizing the static electricity of the substrate S.

In addition, a distance d1 between the first electrode 116 and the second electrode 117 in the first direction X may be smaller than a width SW1of the substrate S in the first direction X. As the distance d1 between the first electrode 116 and the second electrode 117 decreases, the intensity of the electric field between the first electrode 116 and the second electrode 117 increases. Therefore, when the intensity of the static electricity of the substrate S is high, it may be advantageous to reduce the distance d1 between the first electrode 116 and the second electrode 117.

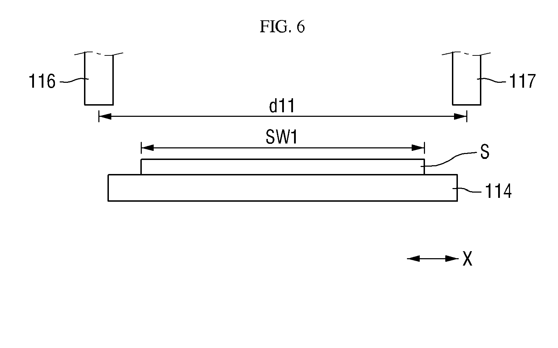

FIG. 6 is a cross-sectional view illustrating another positional relationship among the first electrode 116, the second electrode 117, and the substrate S of FIG. 3.

In FIG. 6, a distance d11 between the first electrode 116 and the second electrode 117 in the first direction X is greater than the width SW1 of the substrate S in the X direction, as compared with the embodiment of FIGS. 3 through 5. In this case, the entire area of the substrate S is exposed to an electric field between the first electrode 116 and the second electrode 117 in the first direction X. Thus, static electricity can be uniformly removed from the entire area of the substrate S in the first direction X.

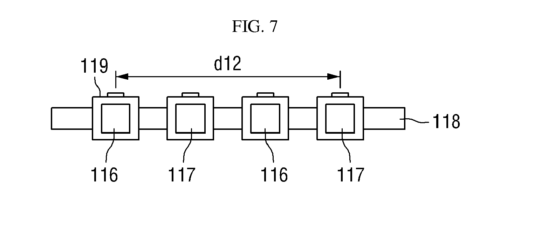

FIG. 7 is a bottom view illustrating another arrangement of the first electrode 116 and the second electrode 117 which is different from the arrangement of FIG. 4.

In FIG. 7, the first electrode 116 and the second electrode 117 are alternately arranged along the first direction X (see FIG. 3) of the substrate stage 114 (see FIG. 3) to form a column consisting of two or more electrodes, for example, four electrodes. In this case, an electric field is formed between each adjacent pair of the first electrode 116 and the second electrode 117 in the column. Thus, the intensity of the electric field may be uniform along the first direction X. If only one pair of the first electrode 116 and the second electrode 117 is formed in one column, the intensity of the electric field may be lowest at a midpoint between the first electrode 116 and the second electrode 117. Accordingly, the effect of neutralizing static electricity may be weakest at a portion of the substrate S (see FIG. 3) which corresponds to the midpoint. However, if the electric field is formed between each adjacent pair of the first electrode 116 and the second electrode 117 in the column, the weak effect of neutralizing static electricity can be compensated for. A distance d12 between an outermost first electrode 116 and an outermost second electrode 117 in the first direction X may be smaller or greater than the width SW1 of the substrate S (see FIG. 3) in the first direction X.

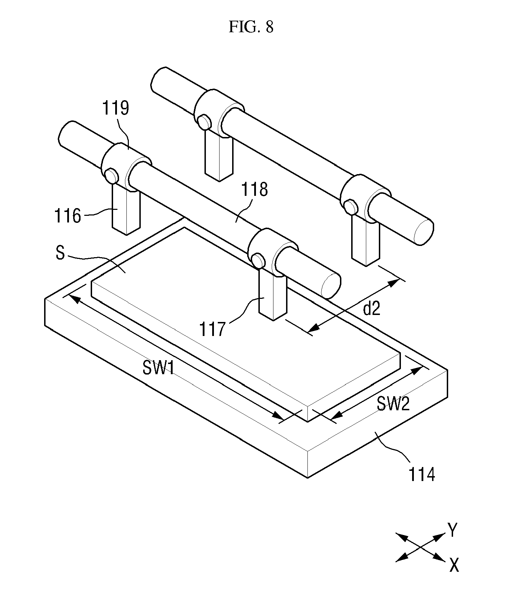

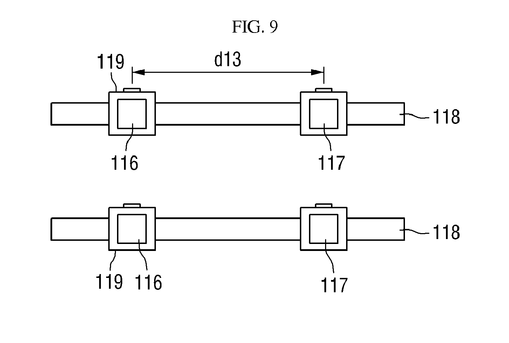

FIG. 8 is a perspective view of another example of the first electrode 116, the second electrode 117, and the substrate S of FIG. 3. FIG. 9 is a bottom view of first electrodes 116, second electrodes 117, and fixing units 118 of FIG. 8.

In FIGS. 8 and 9, the first electrode 116 and the second electrode 117 are alternately arranged along the first direction X of the substrate stage 114 to form a column consisting of two or more electrodes, and the column is repeated in the second direction Y perpendicular to the first direction X to form a plurality of columns.

If a plurality of columns of the first electrode 116 and the second electrode 117 are formed, the entire area of the substrate S may be exposed to an electric field between the first electrode 116 and the second electrode 117 in the second direction Y. Therefore, there may ne no need to move the substrate stage 114 along the second direction Y. In the section direction Y, a distance d2 between an outermost first electrode 116 and an outermost second electrode 117 may be equal to or greater than the width SW2 of the substrate S placed on the substrate stage 114. In the first direction X, a distance d13 between an outermost first electrode 116 and an outermost second electrode 117 may be smaller or greater than the width SW1 of the substrate S.

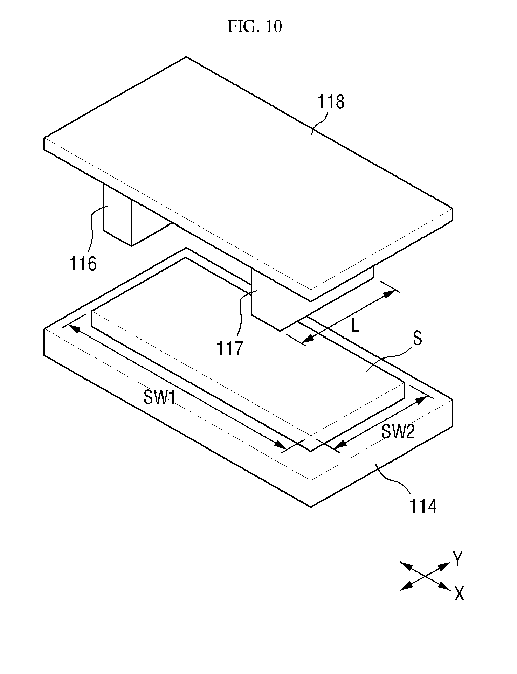

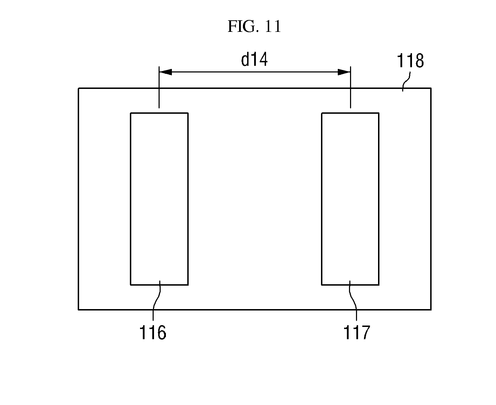

FIG. 10 is a perspective view of another example of the first electrode 116, the second electrode 117, and the substrate S of FIG. 3. FIG. 11 is a bottom view of a first electrode 116, a second electrode 117, and a fixing unit 118 of FIG. 10.

In FIGS. 10 and 11, the first electrode 116 and the second electrode 117 are alternately arranged along the first direction X of the substrate stage 114 to form a column consisting of two or more electrodes. In addition, the first electrode 116 and the second electrode 117 extend along the second direction Y perpendicular to the first direction X.

If the first electrode 116 and the second electrode 117 extend along the second direction Y, the entire area of the substrate S may be exposed to an electric field between the first electrode 116 and the second electrode 117 in the second direction Y. Therefore, there may be no need to move the substrate stage 114 along the second direction Y. In the second direction Y, a length L of each of the first electrode 116 and the second electrode 117 may be equal to or greater than the width SW2 of the substrate S placed on the substrate stage 114. In the first direction X, a distance d14 between an outermost first electrode 116 and an outermost second electrode 117 may be smaller or greater than the width SW1 of the substrate S.

The first electrode 116 and the second electrode 117 extending along the second direction Y may be fixed to the plate-shaped fixing unit 118. In this case, the couplers 119 of FIG. 3 can be omitted.

As described above, the static electricity removing apparatus 100 according to the current embodiment of the present invention can remove static electricity from the substrate S by neutralizing the static electricity of the substrate S using an electric field between the first electrode 116 and the second electrode 117 installed inside the vacuum chamber 111.

Therefore, the static electricity removing apparatus 100 according to the current embodiment of the present invention can prevent the substrate S from being damaged by the static electricity in a process chamber during a process of manufacturing a display device and thus resulting in a problem with the operation of a finished product.

An apparatus for removing static electricity from a substrate according to another embodiment of the present invention will hereinafter be described.

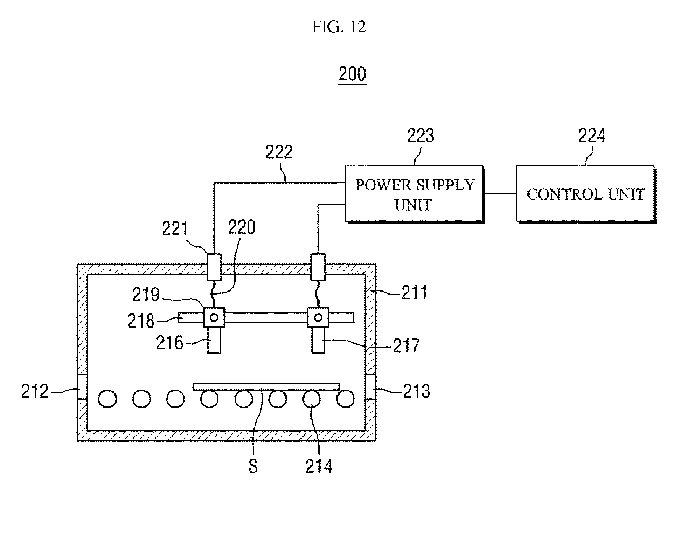

FIG. 12 is a cross-sectional view of an apparatus 200 for removing static electricity from a substrate according to another embodiment of the present invention.

Referring to FIG. 12, the static electricity removing apparatus 200 according to the current embodiment includes a vacuum chamber 211, a substrate stage 214, a first electrode 216, a second electrode 117, a fixing unit 218, couplers 219, a power supply unit 223, and a control unit 224.

The vacuum chamber 211 includes an inlet 212 through which a substrate S is fed into the vacuum chamber 211 and an outlet 213 through which the substrate S is discharged from the vacuum chamber 211. The vacuum chamber 211 is similar to the vacuum chamber 111 of FIG. 1. The vacuum chamber 211 may be a load rock chamber which provides a space where the substrate S is standing by before or after a specific process is performed on the substrate S to manufacture a display device.
The substrate stage 214 is installed inside the vacuum chamber 211. The substrate stage 214 may be a roller which transfers the substrate S fed into the vacuum chamber 211, such that the substrate S can exit the vacuum chamber 211 after a standby. The roller may generate static electricity in the substrate S in the process of transferring the substrate S.

The first electrode 216 and the second electrode 217 are similar to the first electrode 116 and the second electrode 117 of FIG. 1. However, the first electrode 216 and the second electrode 217 are physically separated from the substrate stage 114 at a location immediately before the substrate S exits the vacuum chamber 211. The first electrode 216 and the second electrode 217 play the same roles as the first electrode 116 and the second electrode 117 of FIG. 1, and thus a redundant description thereof will be omitted. In addition, the first electrode 216 and the second electrode 217 may be configured as the first electrode 116 and the second electrode 117 shown in FIGS. 3 through 11.

The fixing unit 218, the couplers 219, the power supply unit 223 and the control unit 224 are similar to the fixing unit 118, the couplers 119, the power supply unit 123 and the control unit 124 of FIG. 1, and thus a redundant description thereof will be omitted. In addition, cables 220, feedthroughs 221 and wirings 222 are similar to the cables 120, the feedthroughs 121 and the wirings 122 of FIG. 1, and thus a redundant description thereof will be omitted.

As described above, the static electricity removing apparatus 200 according to the current embodiment of the present invention can remove static electricity from the substrate S by neutralizing the static electricity using an electric field between the first electrode 216 and the second electrode 217 installed inside the vacuum chamber 211.

Therefore, the static electricity removing apparatus 200 according to the current embodiment of the present invention can prevent the substrate S from being damaged by static electricity in a load lock chamber during a process of manufacturing a display device and thus resulting in a problem with the operation of a finished product.

A method of removing static electricity from a substrate according to still another embodiment of the present invention will hereinafter be described using the static electricity removing apparatus 100 of FIG. 1 as an example.
The static electricity removing method according to the current embodiment may include placing a substrate and forming an electric field.

In the placing of the substrate, at least part of the substrate S mounted on the substrate stage 114 which is installed inside the vacuum chamber 111 is placed under the first electrode 116 and the second electrode 117 which are installed inside the vacuum chamber 115 and are physically separated from the substrate stage 114. To this end, the substrate stage 114 may be placed in advance under the first electrode 116 and the second electrode 117 or may be moved such that part of the substrate S is placed under the first electrode 116 and the second electrode 117 after a specific process is performed on the substrate S.

In the forming of the electric field, an electric field is formed between the first electrode 116 and the second electrode 117 by applying different voltages to the first electrode 116 and the second electrode 117.

If the first electrode 116 and the second electrode 117 are arranged along the first direction X (see FIG. 3) of the substrate stage 114 to form one column, the substrate stage 114 may be horizontally moved along the second direction Y (see FIG. 3), thereby horizontally moving the substrate S in the forming of the electric field. Accordingly, the entire area of the substrate S can be uniformly exposed to the electric field.

In addition, if the one column is repeated along the second direction Y (see FIG. 8) of the substrate stage 114 to form a plurality of columns or if the first electrode 116 and the second electrode 117 extend along the second direction Y (see FIG. 10) of the substrate stage 114, the horizontally moving of the substrate stage 114 along the second direction Y (see FIG. 8 or FIG. 10) may be omitted from the forming of the electric field.

The forming of the electric field may be performed before the substrate S exits the vacuum chamber 110, specifically, immediately before the substrate S is separated from the substrate stage 114.

Embodiments of the present invention provide at least one of the following advantages.

An apparatus for removing static electricity from a substrate according to an embodiment of the present invention can remove static electricity from a substrate by neutralizing the static electricity using an electric field between a first electrode and a second electrode which are installed inside a vacuum chamber.

Therefore, the apparatus for removing static electricity from a substrate according to the embodiment of the present invention can prevent the substrate from being damaged by the static electricity in a process chamber or a load lock chamber during a process of manufacturing a display device and thus resulting in a problem with the operation of a finished product.

As discussed, embodiments of the invention provide an apparatus for removing static electricity from a substrate, the apparatus comprising: a vacuum chamber; a substrate stage which is installed inside the vacuum chamber, the substrate stage being arranged to support a substrate; and a first electrode and a second electrode which are installed inside the vacuum chamber and physically separated from the substrate stage, wherein the apparatus is arranged to form an electric field between the first electrode and the second electrode using different voltages applied to the first electrode and the second electrode, and wherein at least part of the substrate stage is arranged within the electric field.
In some embodiments, the first electrode and the second electrode are arranged along a first direction of the substrate stage to form a column arrangement.

In some embodiments, the column arrangement comprises at least two first electrodes arranged in a first group and comprises at least two second electrodes arranged in a second group separated from the first group; wherein in the first direction, a distance between an outermost first electrode and an outermost second electrode is smaller or greater than a width of a substrate placed on the substrate stage.

In some embodiments, there are a plurality of said column arrangements arranged along the second direction perpendicular to the first direction, wherein in the second direction, a distance between an outermost first electrode and an outermost second electrode is equal to or greater than the width of the substrate placed on the substrate stage.

Embodiments of the invention can also provide a method of removing static electricity from a substrate, the method comprising: placing at least part of a substrate mounted on a substrate stage, which is installed inside a vacuum chamber, between a first electrode and a second electrode which are installed inside the vacuum chamber and physically separated from the substrate stage; and forming an electric field between the first electrode and the second electrode by applying different voltages to the first electrode and the second electrode.

In some embodiments, at least part of the substrate mounted on the substrate stage is placed under the first electrode and the second electrode.

In some embodiments, the electric field is formed before the substrate is separated from the substrate stage.

However, the effects of the present invention are not restricted to the one set forth herein. The above and other effects of the present invention will become more apparent to one of daily skill in the art to which the present invention pertains by referencing the claims.

While the present invention has been particularly shown and described with reference to exemplary embodiments thereof, it will be understood by those of ordinary skill in the art that various changes in form and detail may be made therein without departing from the scope of the present invention as defined by the following claims. The exemplary embodiments should be considered in a descriptive sense only and not for purposes of limitation.

## Claims

1. An apparatus for removing static electricity from a substrate, the apparatus comprising:
a vacuum chamber;
a substrate stage which is installed inside the vacuum chamber, the substrate stage being arranged to support a substrate; and
a first electrode and a second electrode which are installed inside the vacuum chamber and physically separated from the substrate stage,
wherein the apparatus is arranged to form an electric field between the first electrode and the second electrode using different voltages applied to the first electrode and the second electrode, and wherein at least part of the substrate stage is arranged to be within the electric field.

2. The apparatus of claim 1, wherein a positive voltage is applied to the first electrode, and a negative voltage is applied to the second electrode, wherein an absolute value of the positive voltage is equal to an absolute value of the negative voltage.

3. The apparatus of claim 1 or 2, wherein the first electrode and the second electrode are arranged along a first direction of the substrate stage to form a column arrangement.

4. The apparatus of claim 3, wherein the apparatus is arranged to move the substrate stage along a second direction perpendicular to the first direction.

5. The apparatus of claim 3 or 4, wherein in the first direction, a distance between the first electrode and the second electrode is smaller or greater than a width of a substrate placed on the substrate stage.

6. The apparatus of claim 3 or 4, wherein the column arrangement comprises at least two first electrodes arranged in a first group and comprises at least two second electrodes arranged in a second group separated from the first group; wherein in the first direction, a distance between an outermost first electrode and an outermost second electrode is smaller or greater than a width of a substrate placed on the substrate stage.

7. The apparatus of any one of claims 3 to 6, wherein in the second direction perpendicular to the first direction, a width of each of the first electrode and the second electrode is smaller than half a width of the substrate placed on the substrate stage.

8. The apparatus of any one of claims 3 to 7, further comprising:
a bar-shaped fixing unit which is installed inside the vacuum chamber and to which the column is fixed;
couplers which are installed inside the vacuum chamber, coupled respectively to the first electrode and the second electrode, and coupled to the fixing unit such that the couplers can move along the fixing unit;
a power supply unit which is installed outside the vacuum chamber and electrically connected to each of the first electrode and the second electrode so as to apply the different voltages to the first electrode and the second electrode; and
a control unit arranged to control the voltage application of the power supply unit.

9. The apparatus of claim 3 or 4, comprising a plurality of said column arrangements arranged along the second direction perpendicular to the first direction,
wherein in the second direction, a distance between an outermost first electrode and an outermost second electrode is equal to or greater than the width of the substrate placed on the substrate stage.

10. The apparatus of claim 1 or 2, wherein the first electrode and the second electrode are arranged along the first direction of the substrate stage to form a column arrangement that extends along the second direction perpendicular to the first direction,
wherein in the second direction, a length of each of the first electrode and the second electrode is equal to or greater than the width of the substrate placed on the substrate stage.

11. The apparatus of claim 10, further comprising:
a plate-shaped fixing unit which is installed inside the vacuum chamber and to which the first electrode and the second electrode are fixed;
a power supply unit which is installed outside the vacuum chamber and electrically connected to each of the first electrode and the second electrode so as to apply the different voltages to the first electrode and the second electrode; and
a control unit arranged to control the voltage application of the power supply unit.

12. A method of removing static electricity from a substrate, the method comprising:
placing at least part of a substrate mounted on a substrate stage, which is installed inside a vacuum chamber, between a first electrode and a second electrode which are installed inside the vacuum chamber and physically separated from the substrate stage; and
forming an electric field between the first electrode and the second electrode by applying different voltages to the first electrode and the second electrode.

13. The method of claim 12, wherein at least part of the substrate mounted on the substrate stage is placed under the first electrode and the second electrode.

14. The method of claim 12 or 13, further comprising, horizontally moving the substrate by horizontally moving the substrate stage along a second direction perpendicular to a first direction in which the first electrode and the second electrode are arranged,
wherein the forming of the electric field is performed before the substrate exits the vacuum chamber;
wherein before the substrate exits the vacuum chamber is immediately before the substrate is separated from the substrate stage.

15. The method of any one of claims 12 to 14, wherein the electric field is formed before the substrate is separated from the substrate stage.
